# EUROPEAN PATENT APPLICATION

(11) **EP 1 491 966 A1**
(43) Date of publication of application: **29.12.2004**
(21) Application number: 04253685.4
(22) Date of filing: 18.06.2004
(51) Int. Cl.: G03F 7/20, G03F 9/00

(54) **Calibration method for a lithographic apparatus**

(30) Priority: 26.06.2003 EP 03254058
(71) Applicant: ASML Netherlands B.V., 5504 DR Veldhoven (NL)
(72) Inventor: Bleeker, Arno Jan, 5563 CE Westerhoven (NL); Van Buel, H. W. M., 5612 EE Eindhoven (NL); Lof, Joeri, 5616 BW Eindhoven (NL)
(74) Representative: Leeming, John Gerard

(57) **Abstract**

A calibration method comprises: generating a pattern with an array of individually controllable elements (PPM); providing a substrate table (WT) with a radiation sensor; shining radiation to generate an image of the pattern at the substrate table; moving at least one of the generated pattern and the substrate table relative to each other in order to move the image relative to the sensor; detecting radiation intensity with the sensor; and calculating a calibration establishing a relationship between coordinates of the coordinate system of the array of individually controllable elements and coordinates of the coordinate system of the substrate table, based on the detected intensity and the positions of the array of individually controllable elements and the substrate table.

## Description

The present invention relates to a calibration method for a lithographic apparatus and to a device manufacturing method.

A lithographic apparatus is a machine that applies a desired pattern onto a target portion of a substrate. Lithographic apparatus can be used, for example, in the manufacture of integrated circuits (ICs), flat panel displays and other devices involving fine structures, such as micro-electro-mechanical systems (MEMS). In a conventional lithographic apparatus, a patterning means, which is alternatively referred to as a mask or a reticle, may be used to generate a circuit pattern corresponding to an individual layer of the IC (or other device), and this pattern can be imaged onto a target portion (e.g. comprising part of, one or several dies) on a substrate (e.g. a silicon wafer or glass plate) that has a layer of radiation-sensitive material (resist). Instead of a mask, the patterning means may comprise an array of individually controllable elements which serve to generate the circuit pattern.

In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

In a lithographic apparatus, the substrate table will generally be movable and its position within a coordinate system can be known and controlled with very great accuracy, for example using interferometric measuring means. Similarly, if the array of individually controllable elements is movable, then its position within a (different) coordinate system will also be measurable very accurately and, of course, the coordinate of any addressable pixel within the array of individually controllable elements will be very accurately defined. However, although many proposals have been published regarding the use of arrays of individually controllable elements in lithographic projection apparatus, there is hardly any information regarding calibration methods for determining the relationship between the coordinate system of the array of individually controllable elements and the coordinate system of the substrate table. This calibration is, of course, needed so that in order to image a feature at a specific location on a substrate on the substrate table it is known where to generate that feature on the array of individually controllable elements.

There is problem of a lack of known specific procedures for determining the coordinate calibration. Without properly defined calibration methods there exists further problems, such as the calibration might take an excessively long length of time, for example, because certain arrays of individually controllable elements consist of tens of millions of movable mirrors which would have to be calibrated. If the calibration is not properly performed, there is the problem that defective patterns will result. A further problem regarding calibration is that in some lithographic projection apparatus the wafer table and/or array of individually controllable elements are scanned such that they are in motion during the exposure of the pattern and the radiation system may be pulsed. This means that, as well as spatial calibration, it is also necessary to calibrate the timing of the radiation pulses with respect to the velocities of the movable components, because there can be a delay between a trigger signal for the pulse of radiation and the actual emission of the radiation pulse.

It is an object of the present invention to provide a calibration method that can alleviate any of the above problems.

According to an aspect of the invention, there is provided a calibration method, for use with a lithographic projection apparatus comprising:
- an illumination system for supplying a projection beam of radiation;
- an array of individually controllable elements serving to impart the projection beam with a pattern in its cross-section;
- a substrate table for supporting a substrate; and
- a projection system for projecting the patterned beam onto a target portion of the substrate, the method comprising:
   generating a pattern with the array of individually controllable elements;
   providing the substrate table with a radiation sensor;
   shining radiation to generate an image of the pattern at the substrate table;
   moving at least one of the generated pattern and the substrate table relative to each other in order to move the image relative to the sensor;
   detecting radiation intensity with the sensor; and
characterized by
calculating a calibration establishing a relationship between coordinates of the coordinate system of the array of individually controllable elements and coordinates of the coordinate system of the substrate table, based on the detected intensity and the positions of the array of individually controllable elements and the substrate table.

According to a further aspect of the invention there is provided a device manufacturing method comprising:
- providing a substrate;
- providing a projection beam of radiation using an illumination system;
- using an array of individually controllable elements to impart the projection beam with a pattern in its cross-section; and
- projecting the patterned beam of radiation onto a target portion of the substrate, characterized by performing a calibration method as defined above to obtain calibration information; and
- positioning the substrate and the array of individually controllable elements with respect to each other using the calibration information.

According to a yet further aspect of the invention there is provided a computer program for controlling a lithographic apparatus, comprising code means for performing a method as defined above.

The term "array of individually controllable elements" as here employed should be broadly interpreted as referring to any means that can be used to endow an incoming radiation beam with a patterned cross-section, so that a desired pattern can be created in a target portion of the substrate; the terms "light valve" and "Spatial Light Modulator" (SLM) can also be used in this context. Examples of such patterning means include:
- A programmable mirror array. This may comprise a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate spatial filter, the said undiffracted light can be filtered out of the reflected beam, leaving only the diffracted light to reach the substrate; in this manner, the beam becomes patterned according to the addressing pattern of the matrix-addressable surface. It will be appreciated that, as an alternative, the filter may filter out the diffracted light, leaving the undiffracted light to reach the substrate. An array of diffractive optical MEMS devices can also be used in a corresponding manner. Each diffractive optical MEMS device is comprised of a plurality of reflective ribbons that can be deformed relative to one another to form a grating that reflects incident light as diffracted light. A further alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the array of individually controllable elements can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference.
- A programmable LCD array. An example of such a construction is given in United States Patent US 5,229,872, which is incorporated herein by reference.

It should be appreciated that where pre-biasing of features, optical proximity correction features, phase variation techniques and multiple exposure techniques are used, for example, the pattern "displayed" on the array of individually controllable elements may differ substantially from the pattern eventually transferred to a layer of or on the substrate. Similarly, the pattern eventually generated on the substrate may not correspond to the pattern formed at any one instant on the array of individually controllable elements. This may be the case in an arrangement in which the eventual pattern formed on each part of the substrate is built up over a given period of time or a given number of exposures during which the pattern on the array of individually controllable elements and/or the relative position of the substrate changes.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat panel displays, thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multilayer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 408, 355, 365, 248, 193, 157 or 126 nm) and extreme ultra-violet (EUV) radiation (e.g. having a wavelength in the range of 5-20 nm), as well as particle beams, such as ion beams or electron beams.

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables. In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the array of individually controllable elements and the first element of the projection system. Immersion techniques are well known in the art for increasing the numerical aperture of projection systems.

Embodiments of the invention will now be described, by way of example only, with reference to the accompanying schematic drawings in which corresponding reference symbols indicate corresponding parts, and in which:
- Figure 1 depicts a lithographic apparatus according to an embodiment of the invention; and
- Figure 2 depicts schematically, in cross-section, a radiation sensor suitable for use with embodiments of the present invention

### Embodiment 1

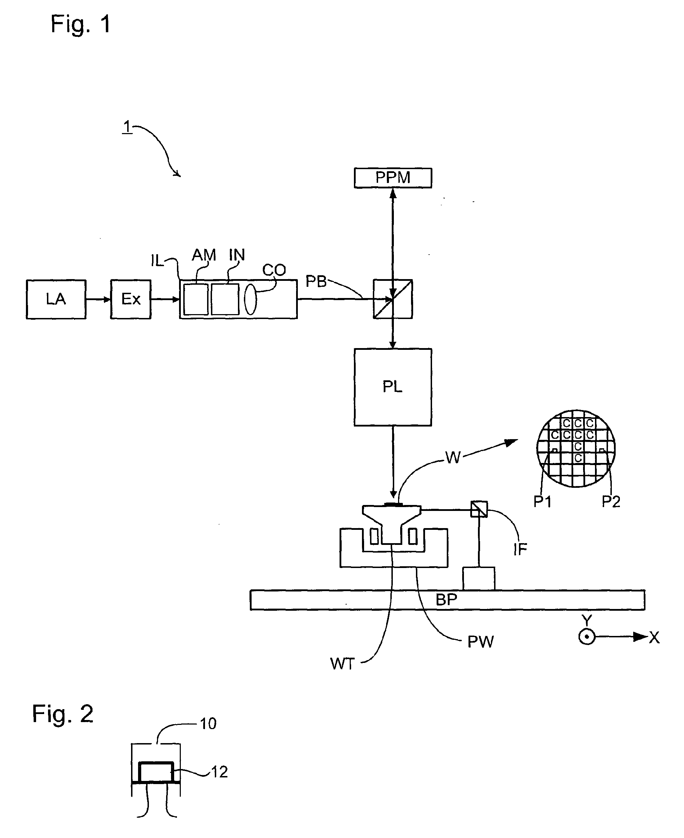

Figure 1 schematically depicts a lithographic projection apparatus according to a particular embodiment of the invention. The apparatus comprises:
- an illumination system (illuminator) IL for providing a projection beam PB of radiation (*e.g.* UV radiation);
- an array of individually controllable elements PPM (e.g. a programmable mirror array) for applying a pattern to the projection beam; in general the position of the array of individually controllable elements will be fixed relative to item PL; however it may instead be connected to a positioning means for accurately positioning it with respect to item PL;
- a substrate table (e.g. a wafer table) WT for supporting a substrate (*e.g.* a resist-coated wafer) W, and connected to positioning means PW for accurately positioning the substrate with respect to item PL; and
- a projection system ("lens") PL for imaging a pattern imparted to the projection beam PB by the array of individually controllable elements PPM onto a target portion C (*e.g.* comprising one or more dies) of the substrate W; the projection system may image the array of individually controllable elements onto the substrate; alternatively, the projection system may image secondary sources for which the elements of the array of individually controllable elements act as shutters; the projection system may also comprise an array of focusing elements such as a micro lens array (known as an MLA) or a Fresnel lens array, *e.g.* to form the secondary sources and to image microspots onto the substrate.

As here depicted, the apparatus is of a reflective type (*i.e.* has a reflective array of individually controllable elements). However, in general, it may also be of a transmissive type, for example (*i.e.* with a transmissive array of individually controllable elements).

The illuminator IL receives a beam of radiation from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising for example suitable directing mirrors and/or a beam expander. In other cases the source may be integral part of the apparatus, for example when the source is a mercury lamp. The source SO and the illuminator IL, together with the beam delivery system BD if required, may be referred to as a radiation system.

The illuminator IL may comprise adjusting means AM for adjusting the angular intensity distribution of the beam. Generally, at least the outer and/or inner radial extent (commonly referred to as σ-outer and σ-inner, respectively) of the intensity distribution in a pupil plane of the illuminator can be adjusted. In addition, the illuminator IL generally comprises various other components, such as an integrator IN and a condenser CO. The illuminator provides a conditioned beam of radiation, referred to as the projection beam PB, having a desired uniformity and intensity distribution in its cross-section.

The beam PB subsequently intercepts the array of individually controllable elements PPM. Having been reflected by the array of individually controllable elements PPM, the beam PB passes through the projection system PL, which focuses the beam PB onto a target portion C of the substrate W. With the aid of the positioning means PW (and interferometric measuring means IF), the substrate table WT can be moved accurately, *e.g.* so as to position different target portions C in the path of the beam PB. Where used, the positioning means for the array of individually controllable elements can be used to accurately correct the position of the array of individually controllable elements PPM with respect to the path of the beam PB, *e.g.* during a scan. In general, movement of the object table WT is realized with the aid of a long-stroke module (course positioning) and a short-stroke module (fine positioning), which are not explicitly depicted in Figure 1. A similar system may also be used to position the array of individually controllable elements. It will be appreciated that the projection beam may alternatively/additionally be moveable while the object table and/or the array of individually controllable elements may have a fixed position to provide the required relative movement. As a further alternative, that may be especially applicable in the manufacture of flat panel displays, the position of the substrate table and the projection system may be fixed and the substrate may be arranged to be moved relative to the substrate table. For example, the substrate table may be provided with a system for scanning the substrate across it at a substantially constant velocity.

Although the lithography apparatus according to the invention is herein described as being for exposing a resist on a substrate, it will be appreciated that the invention is not limited to this use and the apparatus may be used to project a patterned projection beam for use in resistless lithography.

The depicted apparatus can be used in four preferred modes:
1. Step mode: the array of individually controllable elements imparts an entire pattern to the projection beam, which is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.
2. Scan mode: the array of individually controllable elements is movable in a given direction (the so-called "scan direction", e.g. the Y direction) with a speed v, so that the projection beam PB is caused to scan over the array of individually controllable elements; concurrently, the substrate table WT is simultaneously moved in the same or opposite direction at a speed V = Mv, in which M is the magnification of the lens PL. In scan mode, the maximum size of the exposure field limits the width (in the non-scanning direction) of the target portion in a single dynamic exposure, whereas the length of the scanning motion determines the height (in the scanning direction) of the target portion.
3. Pulse mode: the array of individually controllable elements is kept essentially stationary and the entire pattern is projected onto a target portion C of the substrate using a pulsed radiation source. The substrate table WT is moved with an essentially constant speed such that the projection beam PB is caused to scan a line across the substrate W. The pattern on the array of individually controllable elements is updated as required between pulses of the radiation system and the pulses are timed such that successive target portions C are exposed at the required locations on the substrate. Consequently, the projection beam can scan across the substrate W to expose the complete pattern for a strip of the substrate. The process is repeated until the complete substrate has been exposed line by line.
4. Continuous scan mode: essentially the same as pulse mode except that a substantially constant radiation source is used and the pattern on the array of individually controllable elements is updated as the projection beam scans across the substrate and exposes it.

Combinations and/or variations on the above described modes of use or entirely different modes of use may also be employed.

Embodiments of the present invention use a radiation sensor to gather information regarding the position of the aerial image of a pattern generated by the array of individually controllable elements which is imaged in the vicinity of the substrate table. Such a sensor may also be known as a transmission image sensor or TIS. A transmission image sensor is inset into a physical reference surface associated with the substrate table WT. In a particular embodiment, at least one transmission image sensor is mounted on a fiducial plate mounted to the top surface of the substrate table WT, typically outside the area to be covered by the wafer W. The fiducial plate is made of a highly stable material with a very low coefficient of expansion, for example Invar, and has a flat reflective upper surface which may carry markers used with another fiducial in alignment processes.

A transmission image sensor can be used to determine the position of the focal plane of the image, i.e. to determine the relative positions of the array of individually controllable elements and the substrate in the Z direction. Embodiments of the present invention are primarily concerned with calibrating coordinates of the array of individually controllable elements and substrate table in the X Y plane, including displacement in the X and Y directions and rotation about the Z axis.

One example of a transmission image sensor is a spot sensor, as shown in Figure. 2, comprising an aperture 10 in front of a photodiode 12 for sensing all of the radiation that passes through the aperture 10. Typically, the dimensions of the aperture 10 will be approximately the same as the smallest dimensions of features that the lithographic projection apparatus is intended to image. However, any suitable sensor with extremely small detection area could be used. A spot sensor can clearly be used to build up a picture of the image intensity distribution.

A different form of sensor, which is a modified form of the transmission image sensor, can also be used with the calibration method of the present invention. The array of individually controllable elements, such as a micro-mirror array, is set to display a marker pattern, and on the substrate table a photo-detector is covered by a plate in which the same pattern has been formed, taking into account the magnification of the projection system PL. In other words, the aperture 10 of the spot detector in Figure. 2 is replaced by an aperture or a plurality of apertures corresponding to the marker pattern. When the pattern in the plate is coincident with the image of the marker pattern generated by the array of individually controllable elements, a large signal is detected by the photo-detector of the sensor. In alternative versions, the photodiode 12 of the sensor could be replaced by a charge-coupled device (CCD) and integration performed electronically on all of the sensitive elements of the CCD, or the patterned plate could be dispensed with and identification of the image of the marker pattern on the CCD could be performed electronically.

A suitable marker pattern for the calibration procedure of this invention is one or more sets of horizontal and/or vertical gratings. The pitch of the grating or gratings may be determined by the sensor used for the calibration, for example the by the resolution of the sensor or by the grating pitch that can be fabricated in the plate covering the photo-detector described above.

The calibration method according to this first embodiment of the invention is as follows:
(1) A marker pattern is generated on the array of individually controllable elements which matches the pattern of the radiation sensor on the substrate table, as is described above.
(2) The substrate table is moved so that the radiation sensor is positioned in the region in which the image of the marker pattern will be produced.
(3) The laser pulse is fired and the intensity of the radiation is measured at the sensor. A plurality of patterns and radiation sensors may, of course, be provided and used simultaneously.
(4) The marker pattern on the array of individually controllable elements is moved by a specific number of pixels and/or the array of individually controllable elements is moved in the X and Y directions of its coordinate system (in the case in which the array of individually controllable elements is movable).
(5) Steps 3 and 4 are repeated to gather data.
(6) Software is used to calculate the exact position of the array of individually controllable elements with respect to the substrate table using the gathered data to obtain an accurate calibration of the array of individually controllable elements with respect to the substrate table coordinate system.

In this embodiment the substrate table is fixed and the marker pattern is moved to find an optimal position for generating the pattern such that it falls on the radiation sensor. A coarse sweep may be performed initially to find the approximate position for the marker pattern, followed by a fine sweep, such as moving the marker pattern by an increment of only one pixel on the array of individually controllable elements to locate the optimal position. The coordinates of the radiation sensor are known accurately in the coordinate system of the substrate table. The gathered data specifies at what position in the coordinate system of the array of individually controllable elements a marker pattern must be generated such that the image falls on the radiation sensor, and therefore a calibration between the two coordinate systems is determined. For apparatus in which the array of individually controllable elements is movable, calibration is also obtained between the coordinate system of the actuators moving the array of individually controllable elements and the coordinates of the addressable pixels of the array of individually controllable elements.

The distance that the marker pattern is moved at each iteration in the above method, by moving the pattern on the array of individually controllable elements and/or by moving the array of individually controllable elements, may be referred to as the delta step. The minimum delta step does not have to be one pixel, but can be a fraction of a pixel. Also, the ratio of delta step/pixel size (or pixel size/delta step if the delta step is smaller than the pixel size) is preferably not a whole number. When the ratio is close to a whole number, the positional accuracy is no more than the delta step or pixel size, but when the ratio is not a whole number, the calibration accuracy can be improved.

### Embodiment 2

In some examples of lithographic projection apparatus, a plurality of arrays of individually controllable elements is provided, for example a linear or two-dimensional array of individually controllable elements alongside the array of individually controllable elements PPM in Figure. 1. In such apparatus, either one or both of the substrate table and array of individually controllable elements are movable such that a pattern on each array of individually controllable elements can be imaged at the substrate table in turn. Alternatively or additionally the projection system may be adjustable to image each array of individually controllable elements at the substrate table, with or without moving the array of individually controllable elements or substrate table. The method of this embodiment is as follows:
(1) The method of embodiment 1 above is used to determine the position of one array of individually controllable elements relative to the substrate table.
(2) The components of the apparatus are moved as necessary such that a marker pattern on another array of individually controllable elements can be imaged at the substrate table.
(3) The method of embodiment 1 is used to determine the position of the other array of individually controllable elements relative to the substrate table.
(4) Steps 2 and 3 are repeated to measure the position of each array of individually controllable elements. Accordingly, an accurate calibration of all of the arrays of individually controllable elements with respect to each other and to the substrate table coordinate system is obtained.

### Embodiment 3

(1) The method of embodiment 1 is used to determine the position of an off-center (e.g. on the right hand side of the array of individually controllable elements) marker pattern generated on the array of individually controllable elements.
(2) The substrate table is moved to a second position and that position is recorded.
(3) The method of embodiment 1 is used to determine the position of a different off-center (e.g. on the left hand side of the array of individually controllable elements) marker pattern generated on the array of individually controllable elements.
(4) Calculations are performed based on the results of steps 1 and 3 which can yield information on both the magnification of the projection system and calibration regarding the rotation of the array of individually controllable elements with respect to the substrate table coordinate system.
   This method can also be used analogously to embodiment 2 for obtaining accurate rotational calibration of a plurality of arrays of individually controllable elements with respect to each other and to the substrate table coordinate system.

### Embodiment 4

The measurements of any of the above embodiments are done, but keeping the marker pattern on the array of individually controllable elements stationary, and instead scanning the substrate table (with associated radiation detector). This is in contrast to keeping the substrate table stationary and moving the marker pattern on the array of individually controllable elements. For a pulsed radiation system, the exact pulse delay timing needs to be known, but can obtained according to a method described later.

### Embodiment 5

Measurements are performed according to any of the proceeding embodiments, however, the marker pattern on the array of individually controllable elements and the substrate table are both scanned simultaneously, but in perpendicular directions. The method of this embodiment has the advantage that calibration in both the X and Y directions can be performed simultaneously.

### Embodiment 6

A plurality of radiation sensors are provided on the substrate table, for example one for each array of individually controllable elements in the case where there are more than one array of individually controllable elements. This enables the calibration to be performed more quickly.

### Embodiment 7

(1) A method of any of the above embodiments is used to calibrate the array of individually controllable elements with respect to the substrate table coordinate system.
(2) A wafer is provided on the substrate table. The wafer incorporates at least one alignment marker. An off-axis alignment system is used to calibrate the wafer coordinate system (determined by the position and orientation of the at least one alignment marker) with respect to the substrate table coordinate system. An accurate calibration is then obtained between the array of individually controllable elements and the wafer (substrate) coordinate system.

### Embodiment 8

In a method according to any of the above embodiments, instead of using the radiation system to provide a flash of laser light for each position determination, radiation of a longer wavelength is used. This radiation may be called non-actinic light if it does not cause exposure of a pattern on a resist on a substrate. It may also be referred to as "red" light because it is of longer wavelength than the various parts of the ultraviolet spectrum that are typically used, and it may be visible red light, such as from a helium neon laser. Using longer wavelength radiation, other than the normal projection beam radiation, has the advantage that it does not need to be pulsed, and so timing issues for example with respect to embodiment 4 are no longer a problem. It also means that the array of individually controllable elements does not have to be reloaded which is normally the case after each laser flash of actinic radiation.

### Embodiment 9

This embodiment is for calibration of the laser pulse timing.
(1) A marker pattern is generated on the array of individually controllable elements.
(2) The substrate table including the radiation sensor is scanned at constant velocity.
(3) While the substrate table is scanning, a trigger signal is sent to produce a pulse of laser radiation which images the marker pattern at the substrate table.
(4) Laser timing delays and/or errors are detected as placement errors on the sensor. For example, from the coordinate position calibration known from proceeding embodiments, the position of the marker pattern with respect to the resulting position of the image of the marker pattern in the substrate table coordinate system is known with great accuracy. The velocity of the substrate table is also known with great accuracy and thus the difference between the expected position of the image of the marker pattern when the laser pulse trigger signal is generated and the resulting actual position of the image on the substrate table enables the laser timing delay/error to be calculated by dividing the distance between these positions by the velocity of the substrate table. In practice, the steps can be iterated changing either or both of the laser pulse timing and the position of the marker pattern such that the image of the marker pattern falls on the radiation sensor.
In this embodiment, if the scanning speed of the substrate table is essentially the same as used during exposure on a substrate, then a direct calibration between laser pulse trigger timing and image position is obtained, although separate calibration may need to be done for both scan directions to take account of different scanning speeds in different directions.
In a variation of this embodiment, in step (3), instead of firing the laser once to produce a single pulse, in practice the laser is fired multiple times.

While specific embodiments of the invention have been described above, it will be appreciated that the invention may be practiced otherwise than as described. The description is not intended to limit the invention.

## Claims

1. A calibration method, for use with a lithographic projection apparatus comprising:
- an illumination system for supplying a projection beam of radiation;
- an array of individually controllable elements serving to impart the projection beam with a pattern in its cross-section;
- a substrate table for supporting a substrate; and
- a projection system for projecting the patterned beam onto a target portion of the substrate, the method comprising:
generating a pattern with the array of individually controllable elements;
providing the substrate table with a radiation sensor;
shining radiation to generate an image of the pattern at the substrate table;
moving at least one of the generated pattern and the substrate table relative to each other in order to move the image relative to the sensor;
detecting radiation intensity with the sensor; and
**characterized by**
calculating a calibration establishing a relationship between coordinates of the coordinate system of the array of individually controllable elements and coordinates of the coordinate system of the substrate table, based on the detected intensity and the positions of the array of individually controllable elements and the substrate table.

2. Method according to claim 1, wherein the shining, moving and detecting processes are repeated to acquire information for the calculating process.

3. Method according to claim 1 or 2, wherein the moving process comprises scanning at least one of the generated pattern and the substrate table relative to each other while continuously performing the detecting process.

4. Method according to claim 1, 2 or 3, wherein the moving process comprises one or more selected from the group comprising:
moving the pattern generated on the array of individually controllable elements while keeping the substrate table stationary;
moving the array of individually controllable elements while keeping the substrate table stationary;
moving the substrate table while keeping the pattern generated on the array of individually controllable elements stationary;
moving the substrate table while keeping the array of individually controllable elements stationary; and
moving the substrate table and moving at least one of the array of individually controllable elements and the pattern generated on the array of individually controllable elements.

5. Method according to any one of the preceding claims, wherein the distance by which the pattern is moved between successive instances of detecting the radiation intensity is referred to as the delta step, and the ratio of the delta step to the pixel size of the array of individually controllable elements is not a whole number, or when the delta step is less than the pixel size, the ratio of the pixel size to the delta step is not a whole number.

6. Method according to any one of the preceding claims, wherein the moving process comprises moving the substrate table and at least one of the array of individually controllable elements and the pattern on the array of individually controllable elements in different directions, preferably perpendicular directions.

7. Method comprising:
performing the calibration method according to any one of the preceding claims using a pattern generated on a first portion of the array of individually controllable elements; and
repeating the calibration method using a pattern generated on a second portion of the array of individually controllable elements.

8. Method according to claim 7, wherein the first and second portions of the array of individually controllable elements are off-center, preferably on opposite sides of the array of individually controllable elements.

9. Method according to any one of the preceding claims, further comprising: scanning the substrate table; generating a trigger signal to trigger a pulse of radiation from the illumination system while the substrate table is scanning; determining the positional error of the image of the generated pattern resulting from the motion of the substrate table between generation of the trigger signal and emission of the pulse of radiation using the known coordinate calibration; and calculating the radiation delay timing from the positional error.

10. Method according to any one of claims 1 to 8, wherein the process of shining radiation comprises shining radiation with a wavelength longer than that of the projection beam of radiation provided by the illumination system.

11. Method for use with a lithographic projection apparatus comprising a plurality of arrays of individually controllable elements, the method comprising:
performing the calibration method according to any one of the preceding claims for each array of individually controllable elements and displacing the substrate table by a known vector between the calibration for each array of individually controllable elements.

12. Method for use with a lithographic projection apparatus comprising a plurality of arrays of individually controllable elements and a plurality of radiation sensors, comprising performing the calibration method according to any one of the preceding claims using a different respective sensor for each array of individually controllable elements.

13. Method according to any one of the preceding claims, further comprising using an alignment sensor to calibrate coordinates of the substrate table with respect to coordinates of a substrate provided thereon.

14. A device manufacturing method comprising:
- providing a substrate;
- providing a projection beam of radiation using an illumination system;
- using an array of individually controllable elements to impart the projection beam with a pattern in its cross-section; and
- projecting the patterned beam of radiation onto a target portion of the substrate, **characterized by** performing a calibration method according to any one of the preceding claims to obtain calibration information; and
- positioning the substrate and the array of individually controllable elements with respect to each other using the calibration information.

15. A computer program for controlling a lithographic apparatus, comprising code means for performing the method of any one of the preceding claims.
